(19) Europäisches Patentamt / European Patent Office / Office européen des brevets

(11) **EP 3 940 796 A1**

(12) **EUROPEAN PATENT APPLICATION**
published in accordance with Art. 153(4) EPC

(43) Date of publication:
**19.01.2022 Bulletin 2022/03**

(21) Application number: **20916252.8**

(22) Date of filing: **17.07.2020**

(51) International Patent Classification (IPC):
**H01L 31/0352** (2006.01)   **H01L 31/042** (2014.01)
**H01L 21/673** (2006.01)

(52) Cooperative Patent Classification (CPC):
Y02E 10/50

(86) International application number:
**PCT/CN2020/102817**

(87) International publication number:
**WO 2021/232572 (25.11.2021 Gazette 2021/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.05.2020 CN 202010426784**

(71) Applicant: **Risen Energy Co. Ltd**
**Ningbo**
**Zhejiang 315600 (CN)**

(72) Inventor: **HUANG, Qiang**
**Ningbo**
**Zhejiang 315600 (CN)**

(74) Representative: **Berggren Oy**
**P.O. Box 16**
**Eteläinen Rautatiekatu 10A**
**00101 Helsinki (FI)**

(54) **SILICON WAFER/CELL SHEET, PHOTOVOLTAIC CELL ASSEMBLY, CARRIER, AND DESIGN AND ARRANGEMENT METHOD**

(57)     Embodiments of the present disclosure provide a silicon wafer/cell, a photovoltaic cell module and a carrier, and a design and arrangement method, and relate to the field of photovoltaics. The silicon wafer/cell is shaped as a rectangle or a quasi-rectangle with chamfered corners, with two adjacent side lengths of x and y, where x ≠ y, wherein the quasi-rectangle with chamfered corners has a chamfered area not more than 5% of its total area. The photovoltaic cell module is formed by arraying a plurality of the above-mentioned cells. The carrier has an opening, the length of the opening of the carrier is equal to that of a short side of the silicon wafer/cell, and the silicon wafer/cell can be inserted into the opening along its long-side direction. The photovoltaic cell module is formed by arraying cells, is of a specification adapted to restrictions such as those in logistics and glass, and has relatively high power per module. The carrier is suitable for supporting ultra-large silicon wafers/cells. The power of a single module product is maximized by designing and using silicon wafers/cells of a reasonable size in a specific case where the size of the module product is restricted.

FIG. 3

**Description**

**Cross-Reference to Related Applications**

This application claims priority to Chinese Patent Application No. CN202010426784.X, filed with the Chinese Patent Office on May 19, 2020, entitled "Silicon Wafer/Cell, Photovoltaic Cell Module and Carrier, Design and Arrangement Method", which is incorporated herein by reference in its entirety.

**Technical Field**

The present disclosure relates to the field of photovoltaics and, in particular, to a silicon wafer/cell, a photovoltaic cell module and a carrier, and a design and arrangement method.

**Background Art**

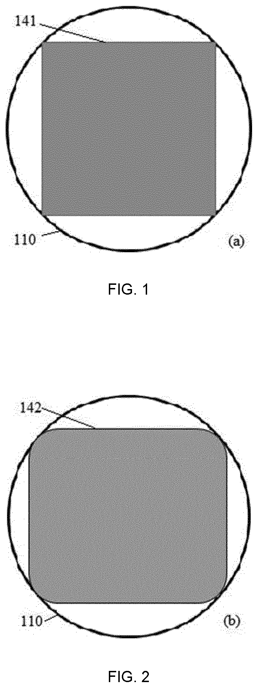

Photovoltaic (PV) is the abbreviation for a solar photovoltaic power system, which usually involves multiple cells arrayed to achieve the maximum effective area within a unit area. The cells are fabricated by processing silicon wafers using conventional cell fabricating processes such as texturing, diffusion, and etching. In general, the size of a cell is equal to the size of a silicon wafer. Currently, photovoltaic cell modules are usually fabricated from symmetrical square (square-shaped) monocrystalline silicon wafers or quasi-square (chamfered square) monocrystalline silicon wafers. Specifically, as shown in FIGS. 1 and 2, FIG. 1 illustrates a schematic diagram of obtaining a square silicon wafer 141 by cutting a silicon rod 110, and FIG. 2 illustrates a schematic diagram of obtaining a quasi-square silicon wafer 142 by cutting a silicon rod 110.

Increasing the size of silicon wafers used in the photovoltaic industry is an important means to increase production throughput and reduce photovoltaic production costs. In recent years, the sizes of silicon wafers have gradually transitioned from 125 mm and 156 mm to square single crystal wafers of 158 mm, quasi-square single crystal wafers of 166 mm, and square single crystal wafers of 210 mm, and the throughput cost for manufacture of photovoltaic cells have been greatly reduced.

On the one hand, the power of current photovoltaic cell modules manufactured using square silicon wafers has exceeded 500 W per module. However, how to achieve a power of 600 W or more per photovoltaic cell module is still a huge challenge in the industry. In addition, not all the sizes of the current photovoltaic cell modules can be perfectly matched, due to restrictions in logistics (dimensions of containers for accommodating and transporting multiple encapsulated photovoltaic cell modules) and in dimensions of glass for encapsulating photovoltaic cell modules. The sizes of photovoltaic cell modules are also limited by optimization of the logistics and glass costs for the photovoltaic cell modules. Therefore, it has been a problem in the industry to put silicon wafers/cells into an optimally sized photovoltaic cell module in a most effective and low-cost manner. For the reasons described above, if the current photovoltaic cell modules using large-size silicon wafers/cells are desired to meet the conditions of optimized logistics cost and cell efficiency of 22.8%, there is still a lot of room for improvement in the power of the photovoltaic cell modules per module.

On the other hand, the efficiency, yield, etc. of ultra-large and ultra-thin silicon wafers are also hugely challenging. Large silicon wafers of 166 mm to 210 mm pose a huge challenge to uniformity in the manufacturing process, especially to the uniformity in key manufacturing processes such as formation of PN junctions by diffusion and formation of SiNx film by PECVD. Since carriers for silicon wafers are provided only at the edges of the silicon wafers, the problems of bending and breakage of silicon wafers become more serious when the silicon wafers become larger, which challenges the thinning of the silicon wafers.

**Summary**

The object of embodiments of the present disclosure includes, for example, providing a silicon wafer/cell, a photovoltaic cell module and a carrier, and a design and arrangement method. The photovoltaic cell module is formed by arraying cells, is of a specification (or size) adapted to restrictions such as those in logistics and glass, and has relatively high power per module. The carrier is suitable for supporting ultra-large silicon wafers/cells. The power of a single module product is maximized by designing and using silicon wafers/cells of a reasonable size in a specific case where the size of the module product is restricted.

An embodiment of the present disclosure provides a silicon wafer/cell, which is shaped as a rectangle or a quasi-rectangle with chamfered corners, with two adjacent side lengths of x and y, where $x \neq y$. The silicon wafer/cell has a size of:

$$y = 155\text{-}240 \text{ mm}, x = 180\text{+/-}8 \text{ mm};$$

or

$$y = 158\text{+/-}5 \text{ mm}, x = 166\text{+/-}5 \text{ mm};$$

or

$$y = 240 \sim 433 \text{ mm}, x = 182 \sim 285 \text{ mm}.$$

In the above-mentioned technical solution, rectangular or quasi-rectangular silicon wafers can be used to obtain cells of the same shape, and the rectangular or quasi-rectangular silicon wafers can be arranged to form a photovoltaic cell module with a larger effective encapsulating area. Especially compared to a photovoltaic cell module with an identical shape and size formed by an arrangement of conventional square cells, a larger effective encapsulating area can be obtained by using the cells of the embodiments of the present disclosure. Also, the output power of the photovoltaic cell module can be increased, and the purpose of maximizing the output power of the product and minimizing the manufacturing cost can be achieved.

In addition, ultra-large and ultra-thin silicon wafers/cells can be formed with a reduced wafer breakage rate by merely enlarging the length of the long sides of the rectangular or quasi-rectangular silicon wafers/cells in the embodiments of the present disclosure. Moreover, if the diffusion distance in at least one of the x and y directions can be shortened, the uniformity can be greatly improved. The improvement of the diffusion uniformity is crucial to an improvement of cell performance. The silicon wafers/cells of the specific size mentioned above are obtained to maximize the effective use of silicon materials and reduce the overall manufacturing cost, where dimensions y = 155~240 mm and x = 180+/-8 mm are conventional dimensions, dimensions y = 158 +/-5 mm and x = 166+/-5 mm are dimensions obtained by the transformation of the old production line, and dimensions y = 240~433 mm and x = 182~285 mm are dimensions corresponding to 18-inch silicon rods.

Optionally, the quasi-rectangle with chamfered corners has a chamfered area not more than 5% of its total area.

Optionally, a diameter D of a cylindrical silicon rod for manufacture of the silicon wafer/cell satisfies $D^2 = x^2 + y^2$ when the silicon wafer/cell is shaped as a rectangle; and a diameter D of a cylindrical silicon rod for manufacture of the silicon wafer/cell satisfies $D^2 < x^2 + y^2$ when the silicon wafer/cell is shaped as a quasi-rectangle.

Optionally, the chamfered corners are rounded corners, arched corners, or beveled corners.

In the above-mentioned technical solution, the quasi-rectangle with chamfered corners is controlled to have a chamfered area not more than 5% of its total area. On the one hand, a silicon wafer with a larger area can be obtained by processing a silicon rod of the same diameter by controlling the quasi-rectangle to have a certain chamfered area. On the other hand, reduction of encapsulating efficiency and of the power of components with a fixed area due to a chamfer margin can be avoided as much as possible by controlling the quasi-rectangle to have a chamfered area not more than 5% of its total area.

An embodiment of the present disclosure provides a photovoltaic cell module, formed mainly by arraying a plurality of cells according to the first aspect or slices thereof, wherein all the cells are of the same specification and arranged in the same direction; the photovoltaic cell module is in the shape of a rectangle with two adjacent side lengths of X and Y, the y sides of all the cells are arranged in m rows along the Y side of the photovoltaic cell module, and the x sides of all the cells are arranged in n columns along the X side of the photovoltaic cell module; the photovoltaic cell module is sized such that X<1150 mm, and the cells are sized and arranged in the following pattern:

$$y = 156\text{-}240 \text{ mm}, x = 180\text{+/-}8 \text{ mm}, m = 5\sim16, n = 6;$$

or

$$y = 158\text{+/-}5 \text{ mm}, x = 166\text{+/-}5 \text{ mm}, m = 5\sim16, n = 6;$$

or

$$y = 240\sim433 \text{ mm}, x = 182\sim285 \text{ mm}, m = 5\sim10, n = 4\sim6.$$

In the above-mentioned technical solution, cells of a suitable size are selected in the embodiment of the present disclosure. The rectangular ultra-large photovoltaic cell module product of the embodiment of the present disclosure formed by arranging cells of the same specification in the same manner can be filled with the cells except the reserved necessary space, so that a larger effective encapsulating area can be obtained, and a larger output power and a lower manufacturing cost can be obtained at the same time.

Optionally, the photovoltaic cell module is sized such that Y<2400 mm and X<1150 mm; and the cells are sized and arranged in the following pattern:

$$y = 180+/-5 \text{ mm}, x = 180+/-8 \text{ mm}, m = 13, n = 6;$$

or

$$y = 195+/-5 \text{ mm}, x = 180+/-8 \text{ mm}, m = 12, n = 6;$$

or

$$y = 213+/-5 \text{ mm}, x = 180+/-8 \text{ mm}, m = 11, n = 6;$$

or

$$y = 235+/-5 \text{ mm}, x = 180+/-8 \text{ mm}, m = 10, n = 6;$$

or

$$y = 240\sim433 \text{ mm}, x = 182\sim285 \text{ mm}, m \leq 9, n \leq 6.$$

The above-mentioned technical solutions are all suitable for casting monocrystalline silicon wafers and forming corresponding photovoltaic cell modules, wherein the above-mentioned first four types of photovoltaic cell modules and cells are proposed mainly for optimization of silicon rod diameters D of cases of about 12 inches (300 mm) and cases of below 12 inches (300 mm). The above-mentioned last type of photovoltaic cell module and cell is proposed mainly for optimization of silicon rod diameters D of cases of about 18 inches (455 mm) and cases of below 18 inches (455 mm).

Photovoltaic cell modules with specific shapes and sizes satisfying Y < 2400 mm and X < 1150 mm can be formed by arraying cells of these sizes. The photovoltaic cell modules provide higher power per module, and such ultra-large photovoltaic cell modules match conventional container sizes and glass sizes and can greatly fill up a container, thereby reducing logistics cost.

Optionally, the photovoltaic cell module is sized such that Y < 2250 mm and X < 1150 mm; and the cells are sized and arranged in the following pattern:

$$y = 158+/-5 \text{ mm}, x = 180+/-8 \text{ mm}, m = 13, n = 6;$$

or

$$y = 166+/-5 \text{ mm}, x = 180+/-8 \text{ mm}, m = 12, n = 6;$$

or

$$y = 235+/-5 \text{ mm}, x = 180+/-8 \text{ mm}, m = 9, n = 6;$$

or

$$y = 235+/-5 \text{ mm}, x = 180+/-8 \text{ mm}, m = 9+1/3, n = 6;$$

or

$$y = 158+/-5 \text{ mm}, x = 166+/-5 \text{ mm}, m = 13, n = 6;$$

or

$$y = 240\sim433 \text{ mm}, x = 182\sim285 \text{ mm}, m < 9, n \le 6.$$

The above-mentioned technical solutions are all suitable for casting monocrystalline silicon wafers and forming corresponding photovoltaic cell modules, wherein the above-mentioned first five types of photovoltaic cell modules and cells are proposed mainly for optimization of silicon rod diameters D of cases of about 12 inches (300 mm) and cases of below 12 inches (300 mm). The above-mentioned last type of photovoltaic cell module and cell is proposed mainly for optimization of silicon rod diameters D of cases of about 18 inches (455 mm) and cases of below 18 inches (455 mm).

Photovoltaic cell modules with specific shapes and sizes satisfying Y < 2250 mm and X < 1150 mm can be formed by arraying cells of these sizes in a certain arrangement manner. The ultra-large photovoltaic cell modules provide higher power per module, and such photovoltaic cell modules are not only adapted to the restrictive conditions in terms of logistics and glass, but also match the dimensions of conventional supports for supporting photovoltaic cell modules in use. There is no need to additionally customize supports for carrying the photovoltaic cell modules, thereby reducing the cost of the supports.

Optionally, the photovoltaic cell module is sized such that Y < 2000 mm and X < 1150 mm; and the cells are sized and arranged in the following pattern:

$$y = 195+/-5 \text{ mm}, x = 180+/-8 \text{ mm}, m = 10, n = 6;$$

or

$$y = 235+/-5 \text{ mm}, x = 180+/-8 \text{ mm}, m = 8+1/3, n = 6;$$

or

$$y = 235+/-5 \text{ mm}, x = 180+/-8 \text{ mm}, m = 8, n = 6;$$

or

$$y = 240\sim433 \text{ mm}, x = 182\sim187 \text{ mm}, m < 8, n \le 6.$$

The above-mentioned technical solutions are all suitable for casting monocrystalline silicon wafers and forming corresponding photovoltaic cell modules, wherein the above-mentioned first three types of photovoltaic cell modules and cells are proposed mainly for optimization of silicon rod diameters D of cases of about 12 inches (300 mm) and cases of below 12 inches (300 mm). The above-mentioned last type of photovoltaic cell module and cell is proposed mainly for optimization of silicon rod diameters D of cases of about 18 inches (455 mm) and cases of below 18 inches (455 mm).

Photovoltaic cell modules with specific shapes and sizes satisfying Y < 2000 mm and X < 1140 mm can be formed by arraying cells of these sizes in a certain arrangement manner. The ultra-large photovoltaic cell modules provide higher power per module, and such photovoltaic cell modules are not only adapted to the restrictive conditions in terms of logistics and glass, but also have the shapes and sizes of conventional photovoltaic cell modules in the U.S. market.

Optionally, the photovoltaic cell module is sized such that Y < 1800 mm and X < 1150 mm; and the cells are sized and arranged in the following pattern:

$$y = 158 +/- 5 \text{ mm}, x = 180 +/- 8 \text{ mm}, m = 11, n = 6;$$

; or

$$y = 166 +/- 5 \text{ mm}, x = 180 +/- 8 \text{ mm}, m = 10, n = 6;$$

or

$$y = 235 +/- 5 \text{ mm}, x = 180 +/- 8 \text{ mm}, m = 6, n = 6;$$

or

$$y = 235 +/- 5 \text{ mm}, x = 180 +/- 8 \text{ mm}, m = 7, n = 6;$$

or

$$y = 158 +/- 5 \text{ mm}, x = 166 +/- 5 \text{ mm}, m = 11, n = 6;$$

or

$$y = 240 \sim 433 \text{ mm}, x = 180 \sim 285 \text{ mm}, m < 7, n \leq 6.$$

The above-mentioned technical solutions are all suitable for casting monocrystalline silicon wafers and forming corresponding photovoltaic cell modules, wherein the above-mentioned first five types of photovoltaic cell modules and cells are proposed mainly for optimization of silicon rod diameters D of cases of about 12 inches (300 mm) and cases of below 12 inches (300 mm). The above-mentioned last type of photovoltaic cell module and cell is proposed mainly for optimization of silicon rod diameters D of cases of about 18 inches (455 mm) and cases of below 18 inches (455 mm).

Photovoltaic cell modules with specific shapes and sizes satisfying Y < 1800 mm and X < 1150 mm can be formed by arraying cells of these sizes in a certain arrangement manner. The ultra-large photovoltaic cell modules provide higher power per module. Such photovoltaic cell modules are not only adapted to the restrictive conditions in terms of logistics and glass, but also are suitable for use in windy environments, such as the windy climate in Guangdong (China), due to their shorter long sides.

Optionally, each of the cells is equally cut in the y direction into f slices before forming the photovoltaic cell module; and optionally f is 2, 3, 4, 6, 8, or 10.

In the above-mentioned technical solution, the cells are each equally cut into f slices and then arrayed in a certain arrangement manner, whereby photovoltaic cell modules of different specifications can be obtained to meet the requirements for actual use of the products. Moreover, the raw materials can be utilized at a higher rate. When a certain part of a cell is damaged or defective, an additional slice(s) can also be cut therefrom. All the slices are partially connected in series and partially connected in parallel with each other, thus the photovoltaic cell module is divided into two symmetrical and independent parts, so that the product can have improved resistance to shadow. When one of the parts is in a mismatched operating state due to shadow, the operation of the other part will not be affected.

Optionally, there is a slice distance of -1.5 to 3 mm between adjacent slices in the Y-side direction;

there is a string distance of -1.5 to 4 mm between adjacent slices along the X side;
creepage distances from the arrayed slices to the X side and Y side are from 9 to 16 mm, respectively; and
there is a convergence distance of 3 to 6 mm between the slices in two parts.

In the above-mentioned technical solution, the slice distance, string distance, creepage distance, and convergence distance are all conventional preset distances to ensure that the reserved space outside the cells (i.e. spaced except the space occupied by the cells) in the photovoltaic cell module is within an appropriate range.

An embodiment of the present disclosure provides a corresponding carrier for the silicon wafer/cell described above, wherein the carrier has an opening, a length of the opening of the carrier is equal to that of a short side of the silicon wafer/cell, and the silicon wafer/cell can be inserted along its long-side direction into the opening; and the length of the opening of the carrier is equal to 180+/-8 mm, 166+/-5 mm, or 158+/-5 mm.

In the above-mentioned technical solution, the opening of the carrier is designed to receive and match a short side of a silicon wafer/cell. The silicon wafer/cell is inserted into the opening along its long-side direction, and the long sides may protrude out from the opening. In this way, the entire silicon wafer/cell can be supported to reduce the wafer breakage rate. The carrier is also applicable to especially a silicon wafer/cell with an area increased by lengthening its long sides, as long as its short sides are kept unchanged. In other words, the carrier of the embodiment of the present disclosure can support ultra-large and ultra-thin silicon wafers/cells to avoid their mechanical bending and can be compatible with silicon wafers of different sizes to reduce time and cost consumption caused by carrier replacement. The carrier has an opening length equal to 180+/-8 mm, 166+/-5 mm, or 158+/-5 mm and thus can be suitable for supporting most of the silicon wafers/cells designed in the embodiments of the present disclosure.

Optionally, supporting sides of the carrier provide continuous supporting or discontinuous supporting.

Optionally, the carrier is a wafer carrying box with one end having an opening, and the opening of the wafer carrying box has an invariable width but a variable length.

An embodiment of the present disclosure provides a design and arrangement method for the photovoltaic cell module described above, which includes the steps of:

presetting restrictive conditions for dimensions of the photovoltaic cell module as Y < 3000 mm and X < 1150 mm, and calculating dimensions x and y of each cell according to a preset arrangement of the cells in the photovoltaic cell module, wherein the dimensions of the cells are calculated by $y \approx (Y-Y1)/m$ and $x \approx (X-X1)/n$ based on different values of m and n and a reserved distance $Y1$ of the photovoltaic cell module at the Y side and a reserved distance $X1$ of the photovoltaic cell module at the X side; and

optimizing a diameter D of a silicon rod corresponding to the cells according to the values of y and x under each restrictive condition to meet the following conditions: the total area of the cell reaches a preset area; and $x^2 + y^2 = D^2$ or $x^2 + y^2 > D^2$.

Optionally, the presetting restrictive conditions for the dimensions of the photovoltaic cell module include: presetting the dimensions of the photovoltaic cell module according to dimensional restrictions in logistics, dimensional restrictions of glass for encapsulating the photovoltaic cell module, applicable environmental restrictions, and the like.

Optionally, all the cells in the photovoltaic cell module are divided into symmetrical and independent upper and lower parts according to the slices, the slices in the upper part and the slices in the lower part are kept connected in series respectively, and the entirety of the slices in the upper part is kept connected in parallel with the entirety of the slices in the lower part.

Optionally, the reserved distance Y1 can be calculated by using the following formula: $Y1 = [\text{slice distance} \times (m \times f \div 2 - 1) + \text{short-side creepage distance}] \times 2 + \text{convergence distance}$, where m is the number of rows of the cells arranged along the long side Y of the photovoltaic cell module, f is the number of slices into which each of the cells is equally cut along its long side, the slice distance is a distance between the adjacent slices in the direction of the long side Y, the short-side creepage distance is a distance between a slice closest to the short side X and the short side X, and the convergence distance is a distance between two adjacent slices of the upper part and the lower part along the long side Y.

Optionally, the reserved distance X1 can be calculated by using the following formula: $X1 = \text{string distance} \times (n-1) + \text{long-side creepage distance} \times 2$, where n is the number of columns of the cells arranged along the short side X of the photovoltaic cell module, the string distance is a distance between the adjacent slices in the direction of the short side X, and the long-side creepage distance is a distance between a slice closest to the long side Y and the long side Y.

Optionally, the optimization of a diameter D of a silicon rod corresponding to the cells according to the values of y and x includes: selecting the diameter D of a cylindrical silicon rod for manufacture of the silicon wafer/cell according to $D^2 = x^2 + y^2$ when the silicon wafer/cell is in the shape of a rectangle; and selecting the diameter D of a cylindrical silicon rod for manufacture of the silicon wafer/cell according to $D^2 < x^2 + y^2$ when the silicon wafer/cell is shaped as a quasi-rectangle.

In the above-mentioned technical solutions, the dimensions of the cells, i.e., the lengths of x and y, and the diameter D of a corresponding silicon rod are adjusted, so that it is ensured that the rectangular or quasi-rectangular cells of the same specification can be arranged reasonably and form a photovoltaic cell module with an optimal size to meet different restrictive conditions, and the effective area of the module is utilized at a maximized rate. In other words, the area of a photovoltaic cell module of a specific size, except the necessary reserved space, can be filled with the areas of the rectangular or quasi-rectangular cells as much as possible, thereby obtaining a larger effective encapsulating area while increasing the efficiency of the module per unit area and the total output power per module.

**Brief Description of the Drawings**

In order to more clearly illustrate technical solutions of embodiments of the present disclosure, drawings required for use in the embodiments will be described briefly below. It is to be understood that the drawings below are merely illustrative of some embodiments of the present disclosure, and therefore should not be considered as limiting its scope. It will be understood by those of ordinary skill in the art that other relevant drawings can also be obtained from these drawings without any inventive effort.

FIG. 1 is a schematic diagram of cutting a square silicon wafer from a silicon rod in the prior art;
FIG. 2 is a schematic diagram of cutting a quasi-square silicon wafer from a silicon rod in the prior art;
FIG. 3 is a schematic diagram of cutting a rectangular cell from a silicon rod and cutting the rectangular cell into slices in an embodiment of the present disclosure;
FIG. 4 is a schematic diagram of cutting a quasi-rectangular cell from a silicon rod and cutting the quasi-rectangular cell into slices in an embodiment of the present disclosure;
FIG. 5 is a schematic diagram of a wafer carrying box supporting silicon wafers in the prior art;
FIG. 6 is a schematic diagram of a wafer carrying box supporting silicon wafers in an embodiment of the present disclosure;
FIG. 7 is another schematic diagram of a wafer carrying box supporting silicon wafers in an embodiment of the present disclosure; and
FIG. 8 is a schematic diagram of arrangement of a photovoltaic cell module in an embodiment of the present disclosure.

Reference Numerals: 110: silicon rod; 121: rectangular cell; 122: quasi-rectangular cell; 123: chamfered corner; 124: slice; 130: wafer carrying box; 140: silicon wafer; 141: square silicon wafer; 142: quasi-square silicon wafer.

**Detailed Description of the Embodiments**

The technical solutions in the embodiments of the present disclosure will be described below with reference to the accompanying drawings in the embodiments of the present disclosure.

In order to further clarify the objects, technical solutions, and advantages of the embodiments of the present disclosure, the technical solutions of the embodiments of the present disclosure will be described below clearly and completely with reference to the drawings of the embodiments of the present disclosure. It is apparent that the embodiments to be described are some, but not all of the embodiments of the present disclosure. Generally, the products of the embodiments of the present disclosure, as described and illustrated in the figures herein, may be arranged and designed in a wide variety of different configurations.

Thus, the following detailed description of the embodiments of the present disclosure, as represented in the figures, is not intended to limit the scope of the present disclosure as claimed, but is merely representative of selected embodiments of the present disclosure. All the other embodiments obtained by those of ordinary skill in the art in light of the embodiments of the present disclosure without inventive efforts will fall within the scope of the present disclosure as claimed.

It should be noted that similar reference numerals and letters refer to similar items in the following figures, and thus once an item is defined in one figure, it may not be further defined or explained in the following figures.

In the description of the present disclosure, it should be noted that the terms such as "center", "up", "down", "inside", and "outside" indicate the orientation or positional relationships shown based on the figures, or the orientation or positional relationships in which the inventive product is conventionally placed in use, and these terms are intended only to facilitate the description of the present disclosure and simplify the description, but not intended to indicate or imply that the referred devices or elements must be in a particular orientation or constructed or operated in the particular orientation, and therefore should not be construed as limiting the present disclosure.

In the description of the present disclosure, it should also be noted that terms "set", "mount", and "connect" should be understood in a broad sense unless otherwise expressly specified or defined. For example, connection may be fixed connection or detachable connection or integral connection, may be mechanical connection or electric connection, or may be direct coupling or indirect coupling via an intermediate medium or internal communication between two elements. The specific meanings of the above-mentioned terms in the present disclosure can be understood by those of ordinary skill in the art according to specific situations.

Silicon wafers/cells, photovoltaic cell modules and carriers, and design and arrangement methods according to the embodiments of the present disclosure will be described in detail below.

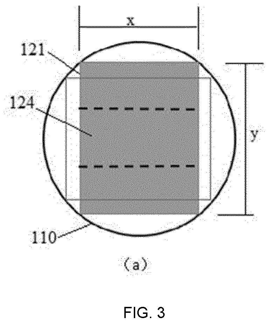

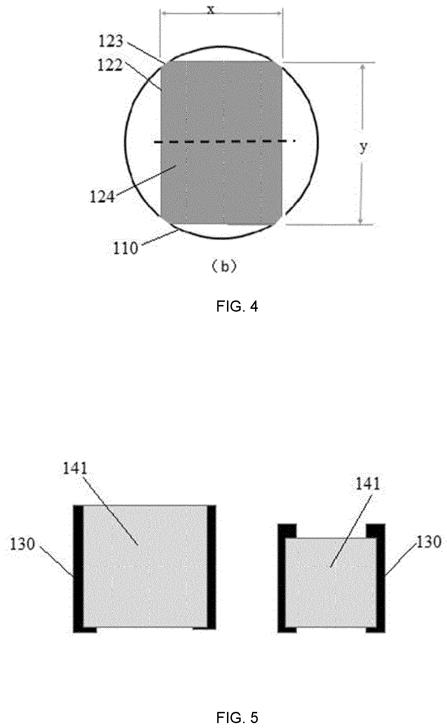

Referring to FIGS. 3 and 4, an embodiment of the present disclosure provides a cell, which is shaped as a rectangle (rectangular cell 121) or a quasi-rectangle (quasi-rectangular cell 122) having chamfered corners 123, with two adjacent side lengths of x and y, where x ≠ y, wherein the area of the chamfered corners 123 (or the chamfered area) of the quasi-rectangular cell 122 with the chamfered corners 123 is not more than 5% of its total area.

A case of manufacture of monocrystalline silicon wafers by Czochralski is taken into consideration. The silicon wafers are processed from a silicon rod 110. Usually, an outer partial rod body is cut off from a silicon rod 110 with a circular bottom surface (i.e. a cylindrical silicon rod) to form a rod body with a rectangular or quasi-rectangular bottom surface, which is then sliced in a direction perpendicular to the axial direction of the rod body (a direction parallel to the bottom surface) to obtain silicon wafers. If the silicon rod 110 corresponding to the cells has a diameter D, the rectangular cell 121 is formed as an inscribed rectangle in a circle concentric with the corresponding silicon rod 110, namely, $x^2 + y^2 = D^2$, and the quasi-rectangular cell 122 with chamfered corners 123 is formed as an inscribed quasi-rectangle with chamfered corners 123 in a circle concentric with the silicon rod 110, namely, $x^2 + y^2 > D^2$, in order to minimize the loss of the silicon rod 110 during the processing (minimize the part cut off therefrom).

Considering a case of manufacture of monocrystalline silicon wafers from ingots, x and y may be set arbitrarily as required, which is more convenient for use.

It should be noted that since a cell is fabricated by processing a silicon wafer by conventional cell fabricating processes such as texturing, diffusion, and etching with almost no change in size, the shape and size of a silicon wafer defined in an example of the present disclosure are regarded as a definition of the shape and size of a corresponding cell, and a definition of the shape and size of a cell is also regarded as a definition of the shape and size of a corresponding silicon wafer.

The term "rectangle" mentioned in the present disclosure refers to a rectangle with four right-angled corners and with two adjacent side lengths x ≠ y, i.e., an asymmetrical rectangle (excluding the case of a square), where the side lengths x and y refer to the lengths of two adjacent right-angled sides.

The term "quasi-rectangle" refers to a shape approximating a rectangle but provided with chamfered corners 123 at the four corners. The "chamfered corners 123" refer to rounded, arched, or beveled corners formed by removing a part from right-angled corners. The side lengths x and y of the quasi-rectangle refer to the lengths of two adjacent right-angled sides of a corresponding rectangle, and the rectangle corresponding to the quasi-rectangle refers to a rectangle formed by extending and connecting the four straight sides of the quasi-rectangle other than the chamfered parts. The "area of the chamfered corners 123" refers to the area of the parts removed from the corresponding rectangle, i.e., the area of regions between the edges of the chamfered corners 123 and the right-angled edges of the corresponding rectangle.

Generally, the four corners of the quasi-rectangle with chamfered corners 123 in the embodiment of the present disclosure are all chamfered corners 123 and are the same as each other. In other words, they are all rounded corners, arched corners, or beveled corners. Silicon wafers in the shape of a quasi-rectangle having four corners formed as the same chamfered corners can be conveniently processed from a silicon rod, and cells having such shape are also easily cut into slices having the same area and evenly arranged to form the photovoltaic cell module. Of course, in some specific cases, the four corners of the quasi-rectangle may also be formed as different chamfered corners according to specific requirements. For example, some are rounded corners and the other ones are beveled corners.

The silicon wafer/cell in the embodiment of the present disclosure usually has a thickness of 80 to 200 μm, in order to save materials. Especially when the silicon wafer/cell is controlled to have a thinner thickness, the advantages of the ultra-large and ultra-thin silicon wafer/cell of the present disclosure can be better reflected.

In an embodiment of the present disclosure, the silicon wafer/cell has a size of:

y = 155 ~ 240 mm, x = 180+/-8 mm (i.e., 172 ~ 188 mm);

or

y = 158+/-5 mm, x = 166+/-5 mm;

or

y = 240 ~ 433 mm, x = 182 ~ 285 mm.

Specifically, the silicon wafer/cell has a size of:

$$y = 158+/-5 \text{ mm (optionally } 155 \sim 163 \text{ mm)}, x = 180+/-8 \text{ mm};$$

or

$$y = 166+/-5 \text{ mm}, x = 180+/-8 \text{ mm};$$

or

$$y = 180+/-5 \text{ mm}, x = 180+/-8 \text{ mm};$$

or

$$y = 195+/-5 \text{ mm}, x = 180+/-8 \text{ mm};$$

or

$$y = 213+/-5 \text{ mm}, x = 180+/-8 \text{ mm};$$

or

$$y = 235+/-5 \text{ mm}, x = 180+/-8 \text{ mm};$$

or

$$y = 158+/-5 \text{ mm}, x = 166+/-5 \text{ mm};$$

or

$$y = 240 \sim 433 \text{ mm}, x = 182 \sim 285 \text{ mm}.$$

In an implementation, a silicon wafer cell of a rectangular shape may be provided. As illustrated in FIG. 3, the rectangular cell 121 has long sides y and short sides x, where $x \neq y$. The rectangular cell 121 is inscribed in a cylindrical silicon rod 110 with a diameter of D, where $D^2 = x^2 + y^2$. In other words, in the process of manufacturing the rectangular cell, the cell with a desired area can be obtained by merely slightly cutting the edge of the cylindrical silicon rod 110, whereby the waste of materials is reduced and the process difficulty is reduced. It is also noted that the rectangular cell 121 is equally cut into three cell slices, where the two dashed lines indicate positions at which the cell is cut, by which it is meant that the cell is equally cut along its own long side into slices in number of f=3. In practical applications, the cells are arranged in a certain layout to obtain photovoltaic cell modules. The cells may be appropriately cut in order to obtain photovoltaic cell modules of different specifications, thereby meeting the requirements for actual use of the products. Moreover, this can increase the rate of utilization of raw materials. As for the cells 121 shown in FIG. 3, in the process of forming a photovoltaic cell module, 1/3 or 2/3 of the cell 121 may be arranged at an edge of the photovoltaic cell module to obtain a photovoltaic cell module of a desired specification. When a certain part of a cell is damaged or defective, an additional slice can also be obtained by cutting and spliced, so that the cell can be used again.

In another implementation, a silicon wafer cell of a quasi-rectangular shape may be provided. As illustrated in FIG. 4, the quasi-rectangular cell 121 has long sides y and short sides x, where $x \neq y$. The rectangular cell 121 is inscribed in a cylindrical silicon rod 110 with a diameter of D, where $D^2 < x^2 + y^2$. In other words, in the process of manufacturing the rectangular cell, the cell with a desired area can be obtained by merely slightly cutting the edge of the cylindrical silicon rod 110, whereby the waste of materials is reduced and the process difficulty is reduced. It is also noted that the rectangular cell 121 is equally cut into two cell slices, where the dashed lines indicate positions at which the cell is cut, by which it is meant that the cell is equally cut along its long side into slices in number of f=2. Half of the cell 121 may be arranged at an edge of a photovoltaic cell module to obtain a photovoltaic cell module of a desired specification.

An embodiment of the present disclosure provides a photovoltaic cell module, formed mainly by arraying a plurality of cells according to the forgoing embodiment or slices thereof, wherein all the cells are of the same specification and arranged in the same direction. The photovoltaic cell module is in the shape of a rectangle with two adjacent side lengths of X and Y. The y sides of all the cells are arranged in m rows along the Y side of the photovoltaic cell module, and the x sides of all the cells are arranged in n columns along the X side of the photovoltaic cell module. If an array of slices is to be used, the cells are each equally divided into f slices in the y direction before forming the photovoltaic cell module. Generally, each cell is equally divided along the length of y. The typical value of f is 2, 3, 4, 6, 8, or 10, and the common typical value of f is 2, 3, or 6.

In an embodiment of the present disclosure, the photovoltaic cell module may be in the shape of an asymmetric rectangle, namely, $X \neq Y$, or may be in the shape of a square, namely, $X = Y$. The shape of the photovoltaic cell module is contemplated from the points of view of arrangement and actual requirements. In general, the photovoltaic cell module is in the shape of an asymmetrical rectangle, where $Y > X$, and the side lengths of the cells satisfy $y > x$. In other words, the long sides y of the cells are arranged along the long sides Y of the photovoltaic cell module, and the short sides x of the cells are arranged along the short sides X of the photovoltaic cell module. Of course, the cells are not limited to such arrangement. In some cases, $Y > X$, and $y < x$. In other words, the short sides y of the cells can still be arranged along the long sides Y of the photovoltaic cell module, and the long sides x of the cells can still be arranged along the short sides X of the photovoltaic cell module, as long as the number m of rows arranged along the long side Y of the photovoltaic cell module is more than the number n of columns arranged along the short side X of the photovoltaic cell module so that the long side Y is longer than the short side X.

It should be understood that the arrangement of the cells in the cell module is not limited to an arrangement in which y corresponds to the long side Y and x corresponds to the short side X. Preferably, the long sides of the cells correspond to the long side of the cell module, and the short sides of the cells correspond to the short side of the cell module. For example, in the above case where $Y > X$ and $y < x$, it is possible to arrange the long sides x of the cells along the long side Y of the photovoltaic cell module and arrange the short sides y of the cells along the short side X of the photovoltaic cell module, so as to facilitate subsequent equal cutting of the cells along their long sides.

In an embodiment of the present disclosure, the photovoltaic cell module is sized such that $X < 1150$ mm, and the cells are sized and arranged in the following pattern:

$$y = 156 \sim 240 \text{ mm}, x = 180+/-8 \text{ mm}, m = 5 \sim 16, n = 6;$$

or

$$y = 158+/-5 \text{ mm}, x = 166+/-5 \text{ mm}, m = 5 \sim 16, n = 6;$$

or

$$y = 240 \sim 433 \text{ mm}, x = 182 \sim 285 \text{ mm}, m = 5 \sim 10, n = 4 \sim 6.$$

In different cases, in primary consideration of restrictions in size of a container for accommodating and transporting multiple encapsulated photovoltaic cell modules and restrictions in size of glass for encapsulating photovoltaic cell modules and sometimes in also consideration of restrictions in sizes of supports for supporting photovoltaic cell modules in use, conventional sizes in the United States, and sizes in windy environments, the specific sizes and arrangements of the photovoltaic cell modules of the embodiments of the present disclosure mainly include the following four size types:

In the first size type, the photovoltaic cell module is sized such that $Y < 2400$ mm and $X < 1150$ mm.

For a corresponding silicon rod with a diameter D of about 12 inches (300 mm), the rectangular or quasi-rectangular cells are sized such that $y = 235+/-5$ mm, $x = 180+/-8$ mm, $m = 10$, and $n = 6$. In other words, all the cells are arranged in 10 rows and in 6 columns. If $f = 2$ is taken into consideration, namely, if each of the cells is equally cut into two cell slices in the y direction, the cell slices are arranged in 20 rows (i.e., 10 rows $\times$ 2) and in 6 columns. If $f = 3$ is taken into consideration, the cell slices are arranged in 30 rows (i.e., 10 rows $\times$ 3) and in 6 columns.

For silicon rods with other specifications and diameters, the rectangular or quasi-rectangular cells may also be formed in other sizes or arranged in other ways. For example, when a corresponding silicon rod has a diameter D of about 268 mm, the cells may be sized such that $x = 195+/-5$ mm, $y = 180+/-8$ mm, $m = 12$, and $n = 6$.

For silicon rods of other specifications and diameters, the rectangular or quasi-rectangular cells may also be formed in other sizes or arranged in other ways. For example, y = 180+/-5 mm, x = 180+/-8 mm, m = 13, n = 6;

$$y = 213+/-5 \text{ mm}, x = 180+/-8 \text{ mm}, m = 11, n = 6;$$

or

$$y = 240 \sim 433 \text{ mm}, x = 182 \sim 285 \text{ mm}, m \leq 9, n \leq 6.$$

In the second size type, the photovoltaic cell module is sized such that Y < 2200 mm and X < 1150 mm.

For a corresponding silicon rod with a diameter D of about 12 inches (300 mm), the rectangular or quasi-rectangular cells are sized such that y = 235+/-5 mm, x = 180+/-8 mm, m = 9+1/3, and n = 6. In other words, all the cells are arranged in about 9.3 rows and in 6 columns. If f = 3 is taken into consideration, the cell slices are arranged in 28 rows (i.e., 9 rows × 3 + 1 row) and in 6 columns.

Alternatively, y = 235+/-5 mm, x = 180+/-8 mm, m = 9, and n = 6. In other words, all the cells are arranged in 9 rows and in 6 columns. If f = 2 is taken into consideration, the cell slices are arranged in 18 rows (i.e., 9 rows × 2) and in 6 columns.

For a corresponding silicon rod with a diameter D of about 247 mm, the rectangular or quasi-rectangular cells are sized such that y = 166+/-5 mm, x = 180+/-8 mm, m = 12, and n = 6. In other words, all the cells are arranged in 12 rows and in 6 columns. If f = 2 is taken into consideration, the cell slices are arranged in 24 rows (i.e., 12 rows × 2) and in 6 columns.

For silicon rods of other specifications and diameters, the rectangular or quasi-rectangular cells may be formed in other sizes or arranged in other ways. For example, y = 158+/-5 mm, x = 180+/-8 mm, m = 13, n = 6; or

y = 158+/-5 mm, x = 166+/-5 mm, m = 13, n = 6; or
y = 240 ~ 433 mm, x = 182 ~ 285 mm, m < 9, n ≤ 6.

In the third size type, the photovoltaic cell module is sized such that Y < 2000 mm and X < 1150 mm.

For a corresponding silicon rod with a diameter D of about 12 inches (300 mm), the rectangular or quasi-rectangular cells are sized such that y = 235+/-5 mm, x = 180+/-8 mm, m = 8+1/3, and n = 6. In other words, all the cells are arranged in about 8.3 rows and in 6 columns. If f = 3 is taken into consideration, the cell slices are arranged in 25 rows (i.e., 8 rows × 3 + 1 row) and in 6 columns. Alternatively, y = 235+/-5 mm, x = 180+/-8 mm, m = 8, and n = 6. In other words, all the cells are arranged in 8 rows and in 6 columns. If f = 2 is taken into consideration, the cell slices are arranged in 16 rows (i.e., 8 rows × 2) and in 6 columns.

For a corresponding silicon rod with a diameter D of about 265 mm, the rectangular or quasi-rectangular cells are sized such that y = 195+/-5 mm, x = 180+/-8 mm, m = 10, and n = 6. In other words, all the cells are arranged in 10 rows and in 6 columns. If f = 2 is taken into consideration, the cell slices are arranged in 20 rows and in 6 columns.

For a corresponding silicon rod with a diameter D of about 319 mm, the rectangular or quasi-rectangular cells are sized such that y = 195+/-5 mm, x = 180+/-8 mm, m = 7.3, and n = 6. In other words, all the cells are arranged in about 7.3 rows and in 6 columns. If f = 3 is taken into consideration, the cell slices are arranged in 22 rows (i.e., 7 rows × 3 + 1 row) and in 6 columns.

For silicon rods of other specifications and diameters, the rectangular or quasi-rectangular cells may also be formed in other sizes or arranged in other ways. For example, y = 240 - 433 mm, x = 182 - 187 mm, m < 8, and n ≤ 6.

In the fourth size type, the photovoltaic cell module is sized such that Y < 1800 mm and X < 1150 mm.

For a corresponding silicon rod with a diameter D of about 12 inches (300 mm), the rectangular or quasi-rectangular cells are sized such that y = 235+/-5 mm, x = 180+/-8 mm, m = 6, and n = 6. In other words, all the cells are arranged in 6 rows and in 6 columns. If f = 3 is taken into consideration, the cell slices are arranged in 18 rows and in 6 columns.

Alternatively, y = 235+/-5 mm, x = 180+/-8 mm, m = 7, and n = 6. In other words, all the cells are arranged in 7 rows and in 6 columns. If f = 3 is taken into consideration, the cell slices are arranged in 21 rows and in 6 columns.

For a corresponding silicon rod with a diameter D of about 245 mm, the rectangular or quasi-rectangular cells are sized such that y = 166+/-5 mm, x = 180+/-8 mm, m = 10, and n = 6. In other words, all the cells are arranged in 10 rows and in 6 columns. If f = 2 is taken into consideration, the cell slices are arranged in 20 rows and in 6 columns.

For a corresponding silicon rod with a diameter D of about 240 mm, the rectangular or quasi-rectangular cells are sized such that y = 158+/-5 mm, x = 180+/-8 mm, m = 11, and n = 6. In other words, all the cells are arranged in 11 rows and in 6 columns. If f = 2 is taken into consideration, the cell slices are arranged in 22 rows and in 6 columns.

For silicon rods of other specifications and diameters, the rectangular or quasi-rectangular cells may also be formed in other sizes or arranged in other ways. For example, y = 158+/-5 mm, x = 166+/-5 mm, m = 11, n = 6; or y = 240 - 433 mm, x = 180 - 285 mm, m < 7, n ≤ 6.

The photovoltaic cell modules of the above-mentioned four size types in the embodiments of the present disclosure may also be obtained by arranging cells of other sizes in other ways, as long as it is ensured that the cells fill up the photovoltaic cell modules as much as possible. In addition, besides the above-mentioned four size types of photovoltaic cell modules, the ultra-large photovoltaic products of the embodiments of the present disclosure may also be of other size types and are not limited to the cases of the embodiments of the present disclosure.

In practical applications, each cell may be further cut into slices, and the slices obtained after cutting are then pieced together to form a photovoltaic cell module. Each cell may usually be equally cut into 2-6 slices along the y side. The cells are usually cut, because the cells correspond to an excessive current when they are not cut (i.e., f = 1).

FIG. 3 shows a case where a rectangular cell 121 is cut and fabricated from a silicon rod 110, and the rectangular cell 121 is further cut into three slices 124 along the dashed lines. FIG. 4 shows a case where a quasi-rectangular cell 122 with chamfered corners 123 is cut and fabricated from a silicon rod 110, and the quasi-rectangular cell 122 is further cut into two slices 124 along the dashed line.

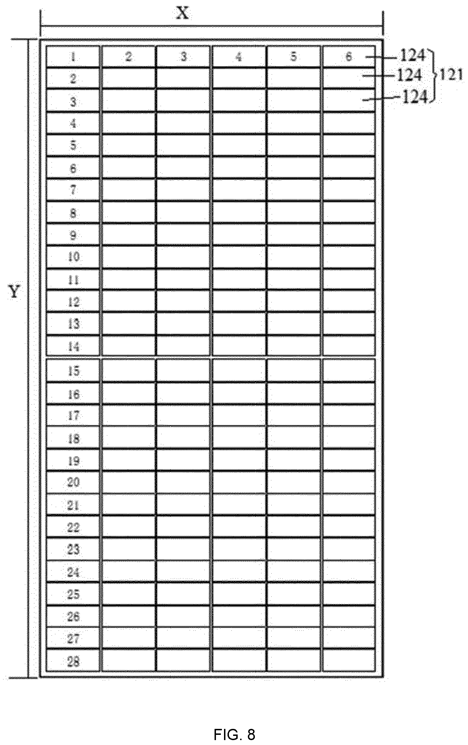

As shown in FIG. 8, all the cells are equally divided into two upper and lower parts along the Y side according to the total number of slices 124. The slices 124 of the two upper and lower parts are connected in series respectively, and the slices 124 of the upper part are connected in parallel with the slices 124 of the lower part. There is a slice distance of -1.5 to 3 mm between adjacent slices 124 in the Y-side direction. There is a string distance of -1.5 to 4 mm between adjacent slices 124 along the X side. The creepage distances (i.e., shortest distance) from slices 124 to the X side and Y side are from 9 to 16 mm respectively, wherein the creepage distance from a slice 124 to the X side is the short-side creepage distance, and the creepage distance from a slice 124 to the Y side is the long-side creepage distance. There is a convergence (or bus) distance of 3 - 6 mm between adjacent ones of slices 124 of the two upper and lower parts. In other embodiments, all the cells are equally divided into three or more parts along the Y side according to the total number of slices 124, and there is a convergence distance of 3 - 6 mm between two adjacent slices 124 of two adjacent parts.

On the basis of the above-mentioned arrangement, the number of cells may be a positive integer or may not be a positive integer. This is because each cell may be further cut into multiple slices 124 according to actual requirements, and it is enough that the total number of the slices 124 is a positive integer. Since the cells are cut in the y direction, n in the x direction is generally a positive integer, and m in the y direction may be a positive integer or may not be a positive integer. It is only necessary to ensure a uniform arrangement of the total number of the divided slices 124.

In addition, the inventors have found during exploration of the present disclosure that in use of the traditional square or quasi-square silicon wafer design, when a large-area silicon wafer is desired, the side lengths of the silicon wafer should be increased. In other words, the center of the silicon wafer will become farther away from any side. A carrier for supporting silicon wafers generally supports edges of only two side of the silicon wafers. When large-area rectangular or quasi-square silicon wafers are supported only at the edges, they are likely to be curved and sag in the middle, which will cause breakage of the wafers. Silicon wafers of different sizes should be collocated with suitable carriers (such as cassettes/flower baskets or wafer carrying boxes) depending on the side lengths of the silicon wafers, and the wafer loading capacity may also decrease.

The inventors expect to reduce a wafer breakage rate while improving the process uniformity during the manufacture of the silicon wafers/cells, to solve the problem of easy breakage of the prior ultra-large and ultra-thin silicon wafers. Therefore, rectangular or quasi-rectangular silicon wafers/cells are designed in the present disclosure, and the short side lengths of the silicon wafers/cells are uniformized as much as possible. Accordingly, it is only necessary to design the openings of conventional carriers (such as cassettes or wafer carrying boxes) to receive the short side lengths of the silicon wafers/cells of the embodiments of the present disclosure. When there is a need to obtain a larger-area silicon wafer/cell, the length of the short sides is controlled unchanged, and only the long sides are lengthened, and the same carrier is collocated for supporting, so that the silicon wafer will not be mechanically bent (curved or sag in the middle) due to the enlargement of the silicon wafer/cell, and thus a silicon wafer/cell which is both larger and thinner can be achieved.

Based on the foregoing explorations and conclusions, an embodiment of the present disclosure provides a carrier corresponding to the silicon wafer/cell according to the forgoing embodiments. The carrier has an opening, the length of the opening of the carrier is equal to the length of the short side of the silicon wafer/cell, and the silicon wafer/cell can be inserted into the opening along its long-side direction. For example, the length of the opening of the carrier is equal to 180+/-8 mm, 166+/-5 mm, or 158+/-5 mm, which can be adapted to most of the cells in the photovoltaic cell modules of the four size types in the embodiments of the present disclosure. Supporting sides of the carrier may provide continuous supporting or discontinuous supporting. When the supporting sides provide discontinuous supporting, the carrier is more conducive to gas diffusion, liquid flowing, or temperature conduction and thus can be used in the diffusion or texturing and cleaning processes in the manufacture of cells to increase manufacturing efficiency and improve uniformity. The carrier may be a wafer carrying box for the above-mentioned silicon wafer/cells. The specific structure of the wafer carrying box will be described in detail hereinafter.

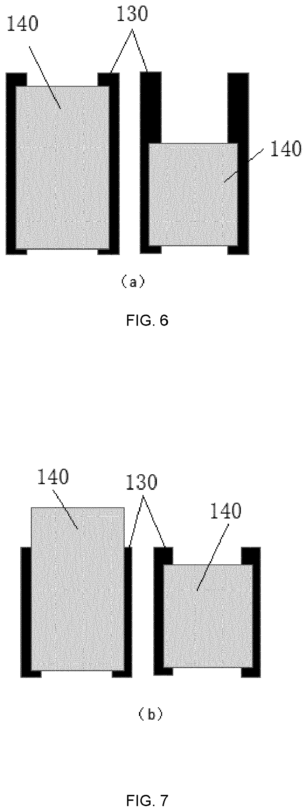

FIG. 5 is a schematic diagram of a wafer carrying box 130 supporting square silicon wafers 141 in the prior art, wherein the wafer carrying box 130 is used for supporting square silicon wafers 141 in the prior art. FIG. 6 and FIG. 7 are schematic diagrams of wafer carrying boxes 103 in embodiments of the present disclosure supporting silicon wafers 140 of embodiments of the present disclosure. It can be seen from FIG. 5 that, in the prior art, square silicon wafers 141 of different sizes should be collocated and supported with wafer carrying boxes 130 of different specifications (with different opening lengths). It can be seen from FIG. 6 and FIG. 7 that a silicon wafer 140 of an embodiment of the present disclosure has long sides mechanically supported and short sides designed and controlled to match the opening of the wafer carrying box 130. Thus, in the embodiment of the present disclosure, the dimension of the short sides of the silicon wafer 140 remains unchanged. In the case where a larger-area silicon wafer is desired, it is only necessary to make the long sides of the silicon wafer 140 longer. With the use of such design, not only a larger-area silicon wafer 140 can be obtained, but also the distance from the center of the silicon wafer 140 to a supported side will not increase due to an increase in the area of the silicon wafer 140. In this way, there is a reduced risk of easy breakage of the silicon wafer due to an excessively long distance from the center of the silicon wafer to the carrier that supports only the edges, and there is no need to replace and adjust the specification of the wafer carrying box 130.

In addition, an embodiment of the present disclosure further provides a design and arrangement method for the photovoltaic cell module according to the foregoing embodiment. The design and arrangement method is based on a concept of forming a photovoltaic cell module product with reduced cost and increased efficiency by arraying asymmetrical cells provided according to an embodiment of the present disclosure, so that the size, specification, and arrangement of the cells are deduced reversely from the perspective of a product restricted by a specific specification. The design and arrangement method of the embodiment of the present disclosure specifically includes the following steps: In S1, restrictive conditions for the dimensions of the photovoltaic cell module, namely, Y and X, are determined as $Y < 3000$ mm and $X < 1500$ mm according to different situations including: dimensional restrictions in logistics (mainly containers for accommodating and transporting multiple encapsulated photovoltaic cell modules), dimensional restrictions of glass for encapsulating photovoltaic cell modules, and applicable environmental restrictions.

The dimensional restrictions of containers and dimensional restrictions of glass for carrying photovoltaic cell modules are considered mainly based on that prior conventional glass carrying modules are used and that the modules are uprightly placed in a container in such a manner that the short sides of the modules are perpendicular to the bottom surface of the container to fill up the container as much as possible and not affect the movement of the modules in the container (enough space should be reserved in the container for allowing a forklift to move the modules). In the embodiments of the present disclosure, according to the dimensional restrictions of containers and dimensional restrictions of glass, the modules are sized with the following four restrictive conditions: (1) $Y < 2400$ mm and $X < 1150$ mm, which are contemplated to match the size of a conventional container and the size of glass to greatly fill up the container and thereby reduce logistics cost; (2) $Y < 2250$ mm and $X < 1150$ mm, which are contemplated based on the restrictive conditions in term of logistics and glass and also match the size of a conventional support for supporting photovoltaic cell modules in use so that there is no need to additionally customize supports for carrying photovoltaic cell modules so as to reduce the cost of the supports; (3) $Y < 2000$ mm and $X < 1150$ mm, which are contemplated based on the restrictive conditions in terms of logistics and glass and are also consistent with conventional specifications and sizes in the United States; and (4) $Y < 1800$ mm and $X < 1150$ mm, which are contemplated based on the restrictive conditions in terms of logistics and glass and are suitable for use in windy environments, such as the windy climate in Guangdong, due to the shorter long sides.

In S2, the dimensions x and y of each cell are calculated according to a preset arrangement of the cells in a high-power photovoltaic cell module. The preset arrangement is such that the y sides of all the cells are arranged in m rows along the Y side of the high-power photovoltaic cell module, and the x sides of all the cells are arranged in n columns along the X side of the photovoltaic cell module. The approximate dimensions of the cells are calculated by $y \approx (Y-Y1)/m$ and $x \approx (X-X1)/n$ based on different values of m and n and a reserved distance Y1 of the photovoltaic cell module at the Y side and a reserved distance X1 of the photovoltaic cell module at the X side.

In general, the cells should also be contemplated to be cut and sliced into f slices. It is preset that each cell is equally divided into f slices along the y side, where $f = 2, 3, 4, 5, 6...$, and the approximate dimensions of the cells are calculated according to different values of m, n, and f.

The reserved distance Y1 of the photovoltaic cell module at the Y side refers to a sum of the creepage distances from the slices to the X sides, the convergence distance, and the slice distances between adjacent slices along the Y side. The reserved distance X1 at the X side refers to a sum of the creepage distances from the slices to the Y sides and the string distances between adjacent slices along the X side. In the embodiment of the present disclosure, all the cells are divided into two symmetrical and independent parts according to the slices, the slices in the two upper and lower parts are kept connected in series respectively, and the slices in the upper part are integrally kept connected in parallel with the slices in the lower part. Accordingly, the total length Y1 in the Y direction required for the slice distances, the convergence distance, and the short-side creepage distances other than the cell areas may be calculated by using the formula Y1 = [slice distance $\times$ ($m \times f \div 2$-1) + short-side creepage distance] $\times$ 2 + convergence distance. For example, when all the cells are arranged in 10 rows along the Y side, and when f = 2, namely, each cell is cut into two slices in the Y direction, Y1 = [slice distance $\times$ ($10 \times 2 \div 2$-1) + short-side creepage distance] $\times$ 2 + convergence distance. The total length X1 in the X direction required for the string distances and the long-side creepage distances other than the cell areas may be calculated by using the formula X1 = string distance $\times$ (n-1) + long-side creepage distance $\times$ 2. For example, if all the cells are arranged in 6 columns along the X side, X1 = string distance $\times$ (6-1) + long-side creepage distance $\times$ 2.

In some embodiments of the present disclosure, the value of m is 5-16, and the value of n is 4, 5, or 6, so that photovoltaic cell modules of specific sizes can be obtained by arrangement with relatively low processing cost. The approximate values of x and y are calculated in a list of different values of m, n, and f by the formulae: $y \approx (Y-Y1)/m$ and $x = (X-X1)/n$, and then x and y are finely adjusted. Optionally, the product of the three numbers f, m, and n is an integer multiple of 2.

In S3, the diameter D of a silicon rod is calculated by $D^2 \approx x^2 + y^2$ according to the values of y and x under each restrictive condition. D is matched to approximate a D value allowing for the lowest cell manufacturing cost that is commonly used in the industry, for example, 300 mm or other values. Optionally, the value of D may be 240+/-5 mm, 250+/-5 mm, 260+/-5 mm, 285+/-5 mm, or 295+/-5 mm. Then, the diameter D of the silicon rod corresponding to the cells is optimized according to the values of y and x to meet the following conditions: the total area of the cell reaches a preset area; and $x^2 + y^2 = D^2$ or $x^2 + y^2 > D^2$.

When y and x satisfy $x^2 + y^2 = D^2$, the cell is formed as an inscribed rectangle in a circle concentric with the corresponding silicon rod. When y and x satisfy $x^2 + y^2 < D^2$, the value of D is adjusted and reduced to satisfy $x^2 + y^2 = D^2$, and the cell is formed as an inscribed rectangle in a circle concentric with the corresponding silicon rod. When y and x satisfy $x^2 + y^2 > D^2$, the cell is formed as a chamfered quasi-rectangle inscribed in a circle concentric with the corresponding silicon rod.

The optimization step includes: fixing the short side length at the same value under different restrictive conditions and adjusting the value of the long side length. This method of fixing the length of the short sides and adjusting only the length of the long sides can reduce the rate of breakage of silicon wafers/cells and solve the problem of breakage of ultra-large and ultra-thin silicon wafers/cells during manufacture and transportation. Specifically, a silicon wafer production line may also be adjusted and optimized. For silicon rods of different diameters D, the axial distance of a slicing machine is determined by the short sides of silicon wafers. After the short sides of the silicon wafers are uniformized, the problem of increased wafer breakage caused by lengthened axial distances of large-area silicon wafers is reduced, and silicon wafers having different areas can be sliced by compatible processes. In addition, the opening sizes of tooling fixtures (such as cassettes, wafer boxes, carrier plates, etc.) in the cell production line and module production line may also be adjusted and optimized so as to be uniformly adjusted to a size appropriate to the short sides of the cells. The cells are physically supported at their long sides.

In S4, a reasonable optimization result is selected from a list of different sizes and different arrangements. The selection criterion is based mainly on a consideration of the power of the corresponding photovoltaic cell module.

In one embodiment, silicon wafer cells 121 are arranged according to the above-mentioned method to form a photovoltaic cell module of a required specification with long sides Y and short sides X, as shown in FIG. 8. Specifically, the restrictive conditions for Y and X are determined according to different situations. Each silicon wafer cell 121 is equally cut into three slices 124 according to f = 3. The slices 124 are arranged in 28 rows along the long side Y of the photovoltaic cell module according to m = 9.1, and the slices 124 are arranged in 6 columns along the short side X of the photovoltaic cell module according to n = 6. The approximate dimensions x and y of the silicon wafer cells 124 are calculated according to different values of m and n and the reserved distance Y1 of the photovoltaic cell module at the Y side and the reserved distance X1 of the photovoltaic cell module at the X side. A silicon rod with the corresponding diameter is selected and used according to the values of x and y, and the edge of the silicon rod is cut to obtain the silicon wafer cells 124. The silicon wafer cells are arranged into a configuration with 9.1 rows and 6 columns according to a preset arrangement to form a photovoltaic cell module of a desired specification.

The features and performance of the present disclosure will be described in further detail below in connection with multiple (four here, where it can be understood that these examples are only exemplary and not restrictive) exemplary examples of the present disclosure.

Each of the listed examples provides photovoltaic cell modules arranged in a variety of specifications, namely, photovoltaic cell modules of Example 1-1, Example 1-2, Example 1-3, Example 1-4, Example 1-5, Example 1-6; Example 2-1, Example 2-2, Example 2-3, Example 2-4, Example 2-5, Example 2-6, Example 2-7; Example 3-1, Example 3-2, Example 3-3, Example 3-4, Example 3-5, Example 3-6; Example 4-1, Example 4-2, Example 4-3, Example 4-4, Example 4-5, and Example 4-6, which are specifically shown in Table 1.

Taking one of the listed examples as an instance, a design and arrangement method for a photovoltaic cell module is carried out according to the following processes:

In S1, restrictive conditions for the dimensions of the photovoltaic cell module are determined such that the long side Y < 2400 mm and the short side X < 1150 mm, in consideration of dimensional restrictive conditions in terms of logistics and glass according to different situations where a 40-feet high-cube container (with a length of 12,020 mm, a width of 2,350 mm, and a height of 2,690 mm) will be used for transportation, a glass width of 1.2 m or less will be contemplated, and sufficient loading and unloading errors will be reserved.

In S2, the cells in the photovoltaic cell module are supposed, according to the above-mentioned restrictive conditions, to be arranged in such a manner that the y sides of all the cells are arranged in m rows along the Y side of the photovoltaic cell module, where m = 13, 12, 11, 10, or 9, the x sides of all the cells are arranged in n columns along the X side of the photovoltaic cell module, where n = 6, and each cell is cut into f slices in the y direction, where f = 2 or 3. The dimensions of the cells are calculated by the formulae: $y \approx (Y-Y1)/m$ and $x \approx (X-X1)/n$ based on different values of m, n, and f (the product of the three values is usually an integer multiple of 2) and the reserved distance Y1 of the photovoltaic cell module at the Y side and the reserved distance X1 of the photovoltaic cell module at the X side, specifically, according to a slice distance of -1 or -1.5 mm between adjacent slices along the Y side, a string distance of 2 or 3 mm between adjacent slices along the X side, a short-side creepage distance and a long-side creepage distance of respectively 14 mm and 13 mm from slices to the X side and the Y side, and a convergence distance of 4 mm between adjacent slices of the divided two upper and lower parts.

In S3, the dimensions of the cells are optimized and selected according to the values of y and x combined with the diameter D (D = 260+/-5 mm, 285+/-5 mm, 295+/-5 mm, or 315+/-5 mm) of a corresponding silicon rod at cell efficiency controlled at 23.2% (the cell efficiency is related to energy density and unrelated to the silicon wafer area) to meet the following conditions: (1) the total area of the cell reaches a preset area; and (2) $x^2 + y^2 = D^2$, where the cell is formed as an inscribed rectangle in a circle concentric with a corresponding silicon rod; or $x^2 + y^2 < D^2$, where the value of D is adjusted and reduced to satisfy $x^2 + y^2 = D^2$ and the cell is formed as an inscribed rectangle in a circle concentric with a corresponding silicon rod; or $x^2 + y^2 > D^2$, where the cell is formed as a chamfered quasi-rectangle inscribed in a circle concentric with a corresponding silicon rod.

In S4, a reasonable optimization result is selected to obtain a photovoltaic cell module with cells of dimensions y = 235.75 mm and x = 182.75 mm arranged in a manner where m is equal to 10, n is equal to 6, and each cell is cut into three slices, namely, Example 1-1 in Table 1.

The photovoltaic cell modules of other examples in Table 1 were obtained according to the same design and arrangement method described above.

In addition, a photovoltaic cell module of Comparative Example 1-a in Table 1 was obtained as a reference according to an arraying method similar to that in Example 1, except that the cells used were square or quasi-square cells.

The power of the ultra-large photovoltaic products of Example 1-1, Example 1-2, Example 1-3, Example 1-4, Example 1-5, Example 1-6, and Comparative Example 1-a was tested per module. The power per module in Example 1 had increased by 35 W or more, compared to that in Comparative Example 1-a under the same restrictive conditions. Thus, it could be found that the power of products per module could be significantly increased by the design and arrangement method according to the embodiment of the present disclosure.

In addition, photovoltaic cell modules of Comparative Example 2-a and Comparative Example 2-b in Table 1 were obtained as references according to an arraying method similar to that in another Example, except that the cells used were square or quasi-square cells.

The power of the ultra-large photovoltaic products of Example 2-1, Example 2-2, Example 2-3, Example 2-4, Example 2-5, Example 2-6, Example 2-7, Comparative Example 2-a, and Comparative Example 2-b was tested per module. Most of the products in Example 2 exhibited increased power per module compared with those in Comparative Example 2-a and Comparative Example 2-b under the same restrictive conditions.

In addition, a photovoltaic cell module of Comparative Example 3-a in Table 1 was obtained as a reference according to an arraying method similar to that in yet another Example, except that the cells used for arraying were square or quasi-square cells.

It could be found, by testing the power of the photovoltaic module products of Example 3-1, Example 3-2, Example 3-3, Example 3-4, Example 3-5, Example 3-6, and Comparative Example 3-a per module, that the power of the products per module could be significantly increased by the design and arrangement method according to the embodiment of the present disclosure. It was found by comparison of Comparative Example 3-a with Example 3 that when the side length dimension of the silicon wafers was fixed at 182 mm, even though the lengths Y of the products were limited to be less than 2000 mm, the power of the products of Examples 3-1 to 3-6 per module had increased by about 15-35 W compared to that of Comparative Example 3-a, which fully proved the superiority of the present disclosure.

## Table 1. Examples of Different Photovoltaic Cell Modules

| No. | Approximate Value of Monocrystalline Silicon Rod Diameter D (mm) | y (mm) | x (mm) | Number of Columns in Horizontal Direction (n) | Number of Rows in Vertical Direction (m) | Equivalent Cell Number | Slice Number (f) | Slice Distance (mm) | String Distance (mm) | Cell Efficiency (%) | Power (W) | Convergence Distance (mm) | Long-side Creepage Distance (mm) | Short-side Creepage Distance (mm) | Product Length (mm) | Product Width (mm) |
|---|---|---|---|---|---|---|---|---|---|---|---|---|---|---|---|---|
| 1 | | | | | | | | | | | | | | | | |
| 1-a | 297 | 210.00 | 210.00 | 5 | 11 | 55 | 2 | -1 | 3.0 | 23.2 | 563 | 4 | 14 | 14 | 2351 | 1079 |
| 1-1 | 298 | 235.75 | 182.75 | 6 | 10 | 60 | 3 | -1 | 2.0 | 23.2 | 600 | 4 | 13 | 14 | 2389 | 1133 |
| 1-2 | 298 | 235.75 | 182.75 | 6 | 10 | 60 | 2 | -1.5 | 2.0 | 23.2 | 600 | 4 | 13 | 14 | 2390 | 1133 |
| 1-3 | 319 | 262.00 | 182.75 | 6 | 9 | 54 | 3 | -1 | 2.0 | 23.2 | 600 | 4 | 13 | 14 | 2392 | 1133 |
| 1-4 | 257 | 180.00 | 182.75 | 6 | 13 | 78 | 2 | -1 | 3.0 | 23.2 | 595 | 4 | 14 | 14 | 2377 | 1129 |
| 1-5 | 268 | 195.75 | 182.75 | 6 | 12 | 72 | 2 | -1 | 3.0 | 23.2 | 598 | 4 | 14 | 14 | 2388 | 1129 |
| 1-6 | 281 | 213.50 | 182.75 | 6 | 11 | 66 | 2 | -1 | 3.0 | 23.2 | 597 | 4 | 14 | 14 | 2390 | 1129 |
| 2 | | | | | | | | | | | | | | | | |
| 2-a | 256 | 180.75 | 180.75 | 6 | 12 | 72 | 2 | -1 | 3.0 | 22.8 | 536 | 4 | 14 | 14 | 2208 | 1128 |
| 2-b | 224 | 158.8 | 158.00 | 6 | 13 | 78 | 2 | 3 | 2.0 | 22.8 | 446 | 4 | 13 | 14 | 2197 | 984 |
| 2-1 | 297 | 246.00 | 182.00 | 6 | 9 | 54 | 2 | -1.5 | 2.0 | 23.2 | 561 | 4 | 13 | 14 | 2249 | 1128 |
| 2-2 | 298 | 235.75 | 182.75 | 6 | 9.3 | 56 | 3 | -1 | 2.0 | 22.8 | 550 | 4 | 13 | 14 | 2233 | 1133 |
| 2-3 | 298 | 235.75 | 182.75 | 6 | 9.0 | 54 | 2 | -1 | 2.0 | 22.8 | 530 | 4 | 13 | 14 | 2165 | 1133 |
| 2-4 | 247 | 166.0 | 182.75 | 6 | 12 | 72 | 2 | 3 | 2.0 | 22.8 | 498 | 4 | 14 | 14 | 2119 | 1135 |
| 2-5 | 242 | 158.8 | 182.75 | 6 | 13 | 78 | 2 | 3 | 2.0 | 22.8 | 516 | 4 | 14 | 14 | 2197 | 1135 |
| 2-6 | 230 | 158.8 | 166.00 | 6 | 13 | 78 | 2 | 3 | 3.0 | 22.8 | 469 | 4 | 14 | 14 | 2197 | 1039 |
| 2-7 | 319 | 262.00 | 182.75 | 6 | 6 | 36 | 3 | -1 | 2.0 | 23.2 | 400 | 4 | 13 | 14 | 1615 | 1133 |
| 3 | | | | | | | | | | | | | | | | |
| 3-a | 257 | 182 | 182 | 6 | 10 | 60 | 2 | 1.5 | 2.0 | 22.8 | 453 | 4 | 13 | 14 | 1906 | 1128 |
| 3-1 | 267 | 195 | 182 | 6 | 10 | 60 | 2 | -1 | 2.0 | 22.8 | 486 | 4 | 13 | 14 | 1991 | 1128 |
| 3-2 | 280 | 213 | 182 | 6 | 9 | 54 | 2 | -1 | 2.0 | 22.8 | 477 | 4 | 13 | 14 | 1960 | 1128 |
| 3-3 | 297 | 235 | 182 | 6 | 8 | 48 | 3 | 1.5 | 2.0 | 22.8 | 468 | 4 | 13 | 14 | 1972 | 1128 |
| 3-4 | 297 | 235 | 182 | 6 | 8 | 48 | 2 | 1.5 | 2.0 | 22.8 | 468 | 4 | 13 | 14 | 1960 | 1128 |
| 3-5 | 297 | 235 | 182 | 6 | 8.3 | 50 | 6 | -0.8 | 2.0 | 22.8 | 488 | 4 | 13 | 14 | 1979 | 1128 |
| 3-6 | 319 | 262.00 | 182.75 | 6 | 7.3 | 44 | 3 | -1 | 2.0 | 23.2 | 487 | 4 | 13 | 14 | 1952 | 1133 |
| 4 | | | | | | | | | | | | | | | | |
| 4-a | 256 | 180.75 | 180.75 | 6 | 9 | 54 | 3 | -1 | 2.0 | 22.8 | 402 | 4 | 14 | 14 | 1663 | 1123 |

| 4-1 | 297 | 235 | 182 | 6 | 6 | 36 | 3 | -1 | 2.0 | 22.8 | 351 | 4 | 14 | 14 | 1455 | 1130 |
| 4-2 | 297 | 235 | 182 | 6 | 7 | 42 | 3 | -1 | 2.0 | 22.8 | 410 | 4 | 14 | 14 | 1687 | 1130 |
| 4-3 | 246 | 166 | 182 | 6 | 10 | 60 | 2 | -1 | 2.0 | 22.8 | 413 | 4 | 14 | 14 | 1703 | 1130 |
| 4-4 | 241 | 158 | 182 | 6 | 11 | 66 | 2 | -1 | 2.0 | 22.8 | 433 | 4 | 14 | 14 | 1779 | 1130 |
| 4-5 | 229 | 158 | 166 | 6 | 10 | 60 | 2 | -1 | 2.0 | 22.8 | 359 | 4 | 14 | 14 | 1623 | 1034 |
| 4-6 | 470 | 433.00 | 182.75 | 6 | 6 | 36 | 3 | -1 | 2.0 | 23.2 | 661 | 4 | 13 | 14 | 2641 | 1133 |

It should be noted that not all possibilities are exhaustively listed in Table 1, and more optional embodiments of photovoltaic cell modules can be obtained and should be deemed as falling within the claimed scope of the present disclosure.

In order to better illustrate the description of the present disclosure, Examples 2-2, 2-1, and 1-3 in Table 1 are selected to further illustrate the arrangement and assembly modes of photovoltaic cell modules.

I. Arrangement and Assembly Mode in Example 2-2

FIG. 3 and FIG. 4 illustrate exemplary silicon wafer cutting modes in the present disclosure, wherein the silicon wafer is designed as a rectangle or a chamfered quasi-rectangle. Exemplarily, FIG. 3 shows a silicon wafer cutting mode of Example 2-2 in Table 1.

Specifically, in this example, an arrangement was designed in the following manner:

In S1, restrictive conditions for the dimensions of the photovoltaic cell module were determined such that the long side Y < 2400 mm and the short side X < 1150 mm, in consideration of dimensional restrictive conditions in terms of logistics and glass according to different situations where a 40-feet high-cube container (with a length of 12,020 mm, a width of 2,350 mm, and a height of 2,690 mm) would be used for transportation, a glass width of 1.2 m or less would be contemplated, and sufficient loading and unloading errors would be reserved.

In S2, in this example, the y sides of the cells in the photovoltaic cell module were supposed to be arranged in m=9.3 rows along the Y side of the photovoltaic cell module, the x sides of the cells in the photovoltaic cell module were supposed to be arranged in n=6 columns along the X side of the photovoltaic cell module, and each cell was supposed to be cut into f=3 slices in the y direction.

A slice distance between adjacent slices along the Y side was set to be -1 mm, a short-side creepage distance from slices to the X side was set to be 14 mm, and a convergence distance was set to be 4 mm, and then a reversed distance Y1 of the photovoltaic cell module at the Y side was calculated according to the formula Y1 = [slice distance × (m×f÷2-1) + short-side creepage distance] × 2 + convergence distance. A string distance between adjacent slices along the X side was set to be 2.0 mm, and a long-side creepage distance from slices to the Y side was set to be 13 mm, and then a reserved distance X1 of the photovoltaic cell module at the X side was calculated according to the formula X1 = string distance × (n-1) + long-side creepage distance × 2.

Approximate dimensions of the cells were calculated by the formulae: $y \approx (Y-Y1)/m$ and $x \approx (X-X1)/n$ for the values of m and n and the reserved distance Y1 of the photovoltaic cell module at the Y side and the reserved distance X1 of the photovoltaic cell module at the X side. In this example, the silicon wafer cell was sized such that y = 235.75 mm and x = 182.75 mm.

In S3, a silicon rod diameter D was calculated by $D^2 \approx x^2 + y^2$ according to the values of y and x. D was matched to approximate a D value allowing for the lowest cell manufacturing cost that was commonly used in the industry. In this example, D was selected to be 298 mm. Here, y and x satisfied $x^2 + y^2 = D^2$, and the silicon wafer cell would be formed as an inscribed rectangle in a circle concentric with a corresponding silicon rod. Then, the edge of a cylindrical silicon rod with D of 298 mm was cut off to obtain rectangular silicon wafer cells with y = 235.75 mm and x = 182.75 mm.

The silicon wafer was processed by the following method. Firstly, the edge of the silicon rod with a diameter D of 298 mm was cut perpendicularly to the bottom surface of the silicon rod 110, and the edge skin (leftover material) was removed to form a rectangular silicon rod. Then, the short sides x of the silicon rod were aligned with a gap between guide rollers of a cutting line of a cutting machine so as to give a minimum silicon wafer cutting pitch, which would contribute to reduced wafer breakage in cutting, increased wafer yield, and reduced cost. The cut silicon wafers were put into a wafer carrying box 130 as shown in FIG. 6 or FIG. 7.

In S4, as shown in FIG. 8, after the rectangular cells 121 had been fabricated, each rectangular cell 121 was cut into three slices. The cutting directions were shown by the dashed lines in FIG. 3. Then, the slices 124 were arranged in 6 vertical columns and in 28 horizontal rows to form a photovoltaic cell module as shown in the figure. The photovoltaic cell module followed a configuration commonly used in the industry in which 6x14 slices were connected in series with each other to form an upper half part of a product, 6x14 slices were connected in series with each other to form a lower half part of the product, and then the upper and lower half parts of the product were connected in parallel with each other. Usually, the slices arranged in the above-mentioned manner were encapsulated with a bottom plate and a transparent panel, and output terminals for collecting a current generated by the slices were provided to form the photovoltaic cell module, which would be combined with components such as a support, a controller, and an output cable to form a photovoltaic power generation system.

II. Arrangement and Assembly Mode in Example 2-1

FIG. 4 illustrates a silicon wafer cutting mode of Example 2-1 in Table 1.

Specifically, in this example, an arrangement was designed in the following manner:

In S1, restrictive conditions for the dimensions of the photovoltaic cell module were determined such that the long side Y < 2400 mm and the short side X < 1150 mm, in consideration of dimensional restrictive conditions in terms of logistics and glass according to different situations where a 40-feet high-cube container (with a length of 12,020 mm, a width of 2,350 mm, and a height of 2,690 mm) would be used for transportation, a glass width of 1.2 m or less would be contemplated, and sufficient loading and unloading errors would be reserved.

In S2, in this example, the y sides of the cells in the photovoltaic cell module were supposed to be arranged in m=9 rows along the Y side of the photovoltaic cell module, the x sides of the cells in the photovoltaic cell module were supposed to be arranged in n=6 columns along the X side of the photovoltaic cell module, and each cell was supposed to be cut into f=2 slices in the y direction.

A slice distance between adjacent slices along the Y side was set to be -1.5 mm, a short-side creepage distance from slices to the X side was set to be 14 mm, and a convergence distance was set to be 4 mm, and then a reversed distance Y1 of the photovoltaic cell module at the Y side was calculated according to the formula Y1 = [slice distance $\times$ (m$\times$f$\div$2-1) + short-side creepage distance] $\times$ 2 + convergence distance. A string distance between adjacent slices along the X side was set to be 2.0 mm, and a long-side creepage distance from slices to the Y side was set to be 13 mm, and then a reserved distance X1 of the photovoltaic cell module at the X side was calculated according to the formula X1 = string distance $\times$ (n-1) + long-side creepage distance $\times$ 2.

Approximate dimensions of the cells were calculated by the formulae: y $\approx$ (Y-Y1)/m and x $\approx$ (X-X1)/n for the values of m and n and the reserved distance Y1 of the photovoltaic cell module at the Y side and the reserved distance X1 of the photovoltaic cell module at the X side. In this example, the silicon wafer cell was sized such that y = 246 mm and x = 182 mm.

In S3, a silicon rod diameter D was calculated according to the values of y and x. D was matched to approximate a D value allowing for the lowest cell manufacturing cost that was commonly used in the industry. In this example, D was selected to be 297 mm. Here, y and x satisfied $D^2 < x^2 + y^2$, and the silicon wafer cell would be formed as an inscribed quasi-rectangle in a circle concentric with a corresponding silicon rod. Then, the edge of a cylindrical silicon rod with D of 297 mm was cut to obtain rectangular silicon wafer cells with y = 246 mm and x = 182 mm. In this case, the chamfered area was about 0.7% of the total area.

The silicon wafer was processed by the following method. Firstly, the edge of the silicon rod with a diameter of 297 mm was cut in a direction perpendicular to the bottom surface of the silicon rod, and the edge skin was removed to form a rectangular silicon rod. Then, the short sides x of the silicon rod were aligned with a gap between guide rollers of a cutting line of a cutting machine, and the cut silicon wafers were put into a wafer carrying box as shown in FIG. 6 or FIG. 7.

In S4, after the cells were finished, each cell was cut into two slices. The cutting direction was shown by the dashed line in FIG. 4. Then, the small cell slices were arranged in 6 vertical columns and in 18 horizontal rows to form a photovoltaic cell module similar to that shown in FIG. 8. The photovoltaic cell module followed a configuration commonly used in the industry in which 6x9 slices were connected in series with each other to form an upper half part of a product, 6x9 slices were connected in series with each other to form a lower half part of the product, and then the upper and lower half parts of the product were connected in parallel with each other.

3. Arrangement and Assembly Mode in Example 1-3

An arrangement of slices of the silicon wafer cell in Example 1-3 in Table 1 could be obtained according to the steps of the design and arrangement methods of the examples of the present disclosure described above.

Specifically, the design and arrangement method in Example 1-3 was carried out by the following steps:

In S1, the size of the photovoltaic cell module was determined in consideration of dimensional restrictions in logistics, dimensional restrictions of glass for encapsulating photovoltaic cell modules, and applicable environmental restrictions according to a specific situation. Restrictive conditions for the dimensions of the photovoltaic cell module were determined such that the long side Y < 2400 mm and the short side X < 1150 mm, in a case where a 40-feet high-cube container would be used for transportation, a glass width of 1.2 m or less would be contemplated, and sufficient loading and unloading errors would be reserved.

In S2, in this example, the y sides of the cells in the photovoltaic cell module were supposed to be arranged in m=10 rows along the Y side of the photovoltaic cell module, the x sides of the cells in the photovoltaic cell module were supposed to be arranged in n=6 columns along the X side of the photovoltaic cell module, and each cell was supposed to be cut into f=3 slices in the y direction.

A slice distance between adjacent slices along the Y side was set to be -1 mm, a short-side creepage distance from slices to the X side was set to be 14 mm, and a convergence distance was set to be 4 mm, and then a reversed distance Y1 of the photovoltaic cell module at the Y side was calculated according to the formula Y1 = [slice distance $\times$ (m$\times$f$\div$2-1) + short-side creepage distance] $\times$ 2 + convergence distance. A string distance between adjacent slices along the X side was set to be 2.0 mm, and a long-side creepage distance from slices to the Y side was set to be 13 mm, and then a reserved distance X1 of the photovoltaic cell module at the X side was calculated according to the formula X1 = string distance $\times$ (n-1) + long-side creepage distance $\times$ 2.

Approximate dimensions of the cells were calculated by the formulae: $y \approx (Y-Y1)/m$ and $x \approx (X-X1)/n$ for the values of m and n and the reserved distance Y1 of the photovoltaic cell module at the Y side and the reserved distance X1 of the photovoltaic cell module at the X side. In this example, the silicon wafer cell was sized such that y = 262 mm and x = 182.75 mm.

In S3, a silicon rod diameter D was calculated by $D^2 \approx x^2 + y^2$ according to the values of y and x. D was matched to approximate a D value allowing for the lowest cell manufacturing cost that was commonly used in the industry. In this example, D was selected to be 319 mm. Here, y and x satisfied $x^2 + y^2 = D^2$, and the silicon wafer cell would be formed as an inscribed rectangle in a circle concentric with a corresponding silicon rod. Then, the edge of a cylindrical silicon rod with D of 319 mm was cut to obtain rectangular silicon wafer cells with y = 262 mm and x = 182.75 mm.

The specific cutting method may be carried out by using the above-mentioned silicon wafer processing method, or other common silicon rod processing methods in the art.

In S4, the rectangular silicon wafer cells were arranged to form a photovoltaic cell module with 9 rows (corresponding to 27 rows of the cell slices because f = 3) and 6 columns according to the above preset and correspondingly calculated and selected data.

It can be seen in this example that the silicon wafer cells obtained in this example have a larger area per cell, and the power per module is also increased by 37 W, compared to Comparative Example 3-a. Thus, it can be seen that the embodiments of the present disclosure provide silicon wafer cells with a larger area per cell while allowing for increased power per cell and reduced risk of bending and breakage of the cells.

In summary, the embodiments of the present disclosure provide a silicon wafer/cell, a photovoltaic cell module and a carrier, and a design and arrangement method. The photovoltaic cell module is formed by arraying cells, is of a specification adapted to restrictions such as those in logistics and glass, and has relatively high power per module. The carrier is suitable for supporting ultra-large silicon wafers/cells. The power of a single module product is maximized by designing and using silicon wafers/cells of a reasonable size in a specific case where the size of the module product is restricted.

The above description is merely illustrative of the embodiments of the present disclosure and is not intended to limit the claimed scope of the present disclosure. It will be understood by those skilled in the art that various modifications and variations may be made to the present disclosure. Any modifications, equivalent alternatives, improvements and so on made within the spirit and principle of the present disclosure are intended to be encompassed within the claimed scope of the present disclosure.

**Industrial Applicability**

The embodiments of the present disclosure provide silicon wafer cells, photovoltaic cell modules and carriers, and design and arrangement methods. The silicon wafer cells can be form as ultra-large and ultra-thin silicon wafer/cells with a reduced rate of wafer breakage. Moreover, if the diffusion distance in at least one of the x and y directions can be shortened, the uniformity can be greatly improved. The improvement of the diffusion uniformity is crucial to an improvement of cell performance. A carrier for supporting the silicon wafer cell has short sides remaining unchanged and long supporting sides increasing in length with the increase in the area of the silicon wafer, so that the distance from the center part of the silicon wafer cell to the supported edge will not increase, thereby reducing a risk of sagging and wafer breakage at the center part. A photovoltaic cell module made of such ultra-large and ultra-thin silicon wafer cells is obtained such that the sizes of the cells are optimized, the logistics cost is optimized, and the power of a single photovoltaic cell module is increased.

**Claims**

1. A silicon wafer/cell, shaped as a rectangle or a quasi-rectangle with chamfered corners, with the rectangle or the quasi-rectangle having two adjacent side lengths of x and y, where $x \neq y$, wherein the silicon wafer/cell has a size of:

$$y = 155 \sim 240 \text{ mm}, x = 180+/-8 \text{ mm};$$

$$y = 158+/-5 \text{ mm}, x = 166+/-5 \text{ mm};$$

or

$$y = 240 \sim 433 \text{ mm}, x = 182 \sim 285 \text{ mm}.$$

2. The silicon wafer/cell according to claim 1, wherein the quasi-rectangle with chamfered corners has a chamfered area not more than 5% of a total area of the quasi-rectangle.

3. The silicon wafer/cell according to any one of claims 1 to 2, wherein the chamfered corners are rounded corners, arched corners, or beveled corners.

4. A photovoltaic cell module, formed by arraying a plurality of cells according to claim 1 or slices thereof, wherein all the cells are of a same specification and arranged in a same direction; the photovoltaic cell module is in a shape of a rectangle with two adjacent side lengths of X and Y, the y sides of all the cells are arranged in m rows along the Y side of the photovoltaic cell module, and the x sides of all the cells are arranged in n columns along the X side of the photovoltaic cell module; the photovoltaic cell module is sized such that X < 1150 mm, and the cells are sized and arranged in a following pattern:

$$y = 156 \sim 240 \text{ mm}, x = 180+/-8 \text{ mm}, m = 5 \sim 16, n = 6;$$

$$y = 158+/-5 \text{ mm}, x = 166+/-5 \text{ mm}, m = 5 \sim 16, n = 6;$$

or

$$y = 240 \sim 433 \text{ mm}, x = 182 \sim 285 \text{ mm}, m = 5 \sim 10, n = 4 \sim 6.$$

5. The photovoltaic cell module according to claim 4, wherein the photovoltaic cell module is sized such that Y < 2400 mm and X < 1150 mm; and the cells are sized and arranged in a following pattern:

$$y = 180+/-5 \text{ mm}, x = 180+/-8 \text{ mm}, m = 13, n = 6;$$

$$y = 195+/-5 \text{ mm}, x = 180+/-8 \text{ mm}, m = 12, n = 6;$$

$$y = 213+/-5 \text{ mm}, x = 180+/-8 \text{ mm}, m = 11, n = 6;$$

$$y = 235+/-5 \text{ mm}, x = 180+/-8 \text{ mm}, m = 10, n = 6;$$

or

$$y = 240 \sim 433 \text{ mm}, x = 182 \sim 285 \text{ mm}, m \leq 9, n \leq 6.$$

6. The photovoltaic cell module according to claim 4, wherein the photovoltaic cell module is sized such that Y < 2250 mm and X < 1150 mm; and the cells are sized and arranged in a following pattern:

$$y = 158+/-5 \text{ mm}, x = 180+/-8 \text{ mm}, m = 13, n = 6;$$

$$y = 166+/-5 \text{ mm}, x = 180+/-8 \text{ mm}, m = 12, n = 6;$$

$$y = 235+/-5 \text{ mm}, x = 180+/-8 \text{ mm}, m = 9, n = 6;$$

$$y = 235+/-5 \text{ mm}, x = 180+/-8 \text{ mm}, m = 9+1/3, n = 6;$$

$$y = 158+/-5 \text{ mm}, x = 166+/-5 \text{ mm}, m = 13, n = 6;$$

or

$$y = 240 \sim 433 \text{ mm}, x = 182 \sim 285 \text{ mm}, m < 9, n \leq 6.$$

7. The photovoltaic cell module according to claim 4, wherein the photovoltaic cell module is sized such that Y < 2000 mm and X < 1150 mm; and the cells are sized and arranged in a following pattern:

$$y = 195+/-5 \text{ mm}, x = 180+/-8 \text{ mm}, m = 10, n = 6;$$

$$y = 235+/-5 \text{ mm}, x = 180+/-8 \text{ mm}, m = 8+1/3, n = 6;$$

$$y = 235+/-5 \text{ mm}, x = 180+/-8 \text{ mm}, m = 8, n = 6;$$

or

$$y = 240 \sim 433 \text{ mm}, x = 182 \sim 187 \text{ mm}, m < 8, n \leq 6.$$

8. The photovoltaic cell module according to claim 4, wherein the photovoltaic cell module is sized such that Y < 1800 mm and X < 1150 mm; and the cells are sized and arranged in a following pattern:

$$y = 158+/-5 \text{ mm}, x = 180+/-8 \text{ mm}, m = 11, n = 6;$$

$$y = 166+/-5 \text{ mm}, x = 180+/-8 \text{ mm}, m = 10, n = 6;$$

$$y = 235+/-5 \text{ mm}, x = 180+/-8 \text{ mm}, m = 6, n = 6;$$

$$y = 235+/-5 \text{ mm}, x = 180+/-8 \text{ mm}, m = 7, n = 6;$$

$$y = 158+/-5 \text{ mm}, x = 166+/-5 \text{ mm}, m = 11, n = 6;$$

or

$$y = 240 \sim 433 \text{ mm}, x = 180 \sim 285 \text{ mm}, m < 7, n \leq 6.$$

9. The photovoltaic cell module according to any one of claims 4 to 8, wherein each of the cells is equally cut into f slices in a y direction before forming the photovoltaic cell module; and optionally f is 2, 3, 4, 6, 8, or 10.

10. The photovoltaic cell module according to any one of claims 4 to 9, wherein a slice distance between adjacent slices in a Y-side direction is -1.5 to 3 mm;

> a string distance between adjacent slices along the X side is -1.5 to 4 mm;
> creepage distances from the slices to the X side and Y side are 9~16 mm, respectively; and
> a convergence distance between the slices in two parts is 3~6 mm.

11. A carrier corresponding to the silicon wafer/cell according to claim 1, wherein the carrier has an opening, a length of the opening of the carrier is equal to that of a short side of the silicon wafer/cell, and the silicon wafer/cell is configured to be inserted into the opening in a long-side direction of the silicon wafer/cell; and the length of the opening of the carrier is equal to 180+/-8 mm, 166+/-5 mm, or 158+/-5 mm.

12. The carrier according to claim 11, wherein supporting sides of the carrier provide continuous supporting or discontinuous supporting.

13. The carrier according to claim 11 or 12, wherein the carrier is a wafer carrying box with one end having an opening, and the opening of the wafer carrying box has an invariable width but a variable length.

14. A design and arrangement method for the photovoltaic cell module according to claim 4, comprising steps of:

> presetting restrictive conditions for dimensions of the photovoltaic cell module such that Y < 3000 mm and X < 1150 mm, and calculating dimensions x and y of each cell according to a preset arrangement of the cells in the photovoltaic cell module, wherein the dimensions of the cells are calculated by $y \approx (Y-Y1)/m$ and $x \approx (X-X1)/n$ based on different values of m and n, a reserved distance Y1 of the photovoltaic cell module at a Y side and a reserved distance X1 of the photovoltaic cell module at a X side; and
> optimizing a diameter D of a silicon rod corresponding to the cells according to the values of y and x under each restrictive condition to meet following conditions: a total area of the cell reaches a preset area; and $x^2 + y^2 = D^2$ or $x^2 + y^2 > D^2$.

15. The design and arrangement method according to claim 14, wherein the preset restrictive conditions for the dimensions of the photovoltaic cell module comprise: dimensional restrictions in logistics and dimensional restrictions of glass for encapsulating the photovoltaic cell module.

16. The design and arrangement method according to claim 14 or 15, wherein all the cells in the photovoltaic cell module are divided into symmetrical and independent upper and lower parts according to the slices, the slices in the upper part and the slices in the lower part are kept connected in series respectively, and an entirety of the slices in the upper part is kept connected in parallel with an entirety of the slices in the lower part.

17. The design and arrangement method according to claim 16, wherein a reserved distance Y1 is calculated by using a following formula: Y1 = [slice distance x (m×f÷2-1) + short-side creepage distance] × 2 + convergence distance, where m indicates number of rows of the cells arranged along the long side Y of the photovoltaic cell module, f indicates number of slices into which each of the cells is equally cut along a long side thereof, the slice distance is a distance between the adjacent slices in a direction of the long side Y, the short-side creepage distance is a distance between a slice closest to a short side X and the short side X, and the convergence distance is a distance between two adjacent slices of the upper part and the lower part along the long side Y.

18. The design and arrangement method according to any one of claims 14 to 17, wherein a reserved distance X1 is calculated by using a following formula: X1 = string distance $\times$ (n-1) + long-side creepage distance $\times$ 2, where n indicates number of columns of the cells arranged along the short side X of the photovoltaic cell module, the string distance is a distance between the adjacent slices in the direction of the short side X, and the long-side creepage distance is a distance between a slice closest to the long side Y and the long side Y.

19. The design and arrangement method according to any one of claims 14 to 18, wherein the optimization of a diameter D of a silicon rod corresponding to the cells according to the values of y and x comprises: selecting the diameter D of a cylindrical silicon rod for manufacture of the silicon wafer/cell according to $D^2 = x^2 + y^2$ when the silicon wafer/cell is shaped as the rectangle; and selecting the diameter D of a cylindrical silicon rod for manufacture of the silicon wafer/cell according to $D^2 < x^2 + y^2$ when the silicon wafer/cell is shaped as the quasi-rectangle.

141

110

(a)

FIG. 1

142

110

(b)

FIG. 2

(a)

FIG. 3

FIG. 4

FIG. 5

140  130

140

(a)

FIG. 6

140  130  140

(b)

FIG. 7

FIG. 8

## INTERNATIONAL SEARCH REPORT

International application No.

**PCT/CN2020/102817**

### A. CLASSIFICATION OF SUBJECT MATTER

H01L 31/0352(2006.01)i; H01L 31/042(2014.01)i; H01L 21/673(2006.01)i

According to International Patent Classification (IPC) or to both national classification and IPC

### B. FIELDS SEARCHED

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

VEN; CNABS; CNTXT; EPTXT; WOTXT; USTXT; CNKI: 长方形, 倒角, 拼排, 硅片, 电池片, 光伏组件, 载具, rectangle, chamfer, arrangement, silicon wafer, solar cell, photovoltaic module, carrier

### C. DOCUMENTS CONSIDERED TO BE RELEVANT

| Category* | Citation of document, with indication, where appropriate, of the relevant passages | Relevant to claim No. |
|---|---|---|
| X | CN 110085517 A (JIANGSU HUAHENG NEW ENERGY CO., LTD.) 02 August 2019 (2019-08-02) description, paragraphs 3-25, figure 1 | 1-3, 11-13 |
| X | CN 103022179 A (ZHAO, Junyong) 03 April 2013 (2013-04-03) description, paragraphs 21-44, figure 1 | 1-3 |
| X | CN 103000711 A (ZHAO, Junyong) 27 March 2013 (2013-03-27) description, paragraphs 34-55, and figures 1-6 | 1-3 |
| Y | CN 110085517 A (JIANGSU HUAHENG NEW ENERGY CO., LTD.) 02 August 2019 (2019-08-02) description, paragraphs 3-25, figure 1 | 4-10, 14-19 |
| Y | CN 103022179 A (ZHAO, Junyong) 03 April 2013 (2013-04-03) description, paragraphs 21-44, figure 1 | 4-10, 14-19 |
| Y | CN 106784105 A (JA SOLAR TECHNOLOGY YANGZHOU CO., LTD. et al.) 31 May 2017 (2017-05-31) description, paragraphs 33-77, and figures 1-6 | 4-10, 14-19 |
| Y | CN 103000711 A (ZHAO, Junyong) 27 March 2013 (2013-03-27) description, paragraphs 34-55, and figures 1-6 | 4-10, 14-19 |

☑ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **04 February 2021** | **20 February 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

## INTERNATIONAL SEARCH REPORT

| International application No. |
|---|
| **PCT/CN2020/102817** |

**C.    DOCUMENTS CONSIDERED TO BE RELEVANT**

| Category* | Citation of document, with indication, where appropriate, of the relevant passages | Relevant to claim No. |
|---|---|---|
| Y | CN 209266425 U (SHANGHAI JA SOLAR TECHNOLOGY CO., LTD.) 16 August 2019 (2019-08-16) <br> description, paragraphs 34-58, and figures 1-3 | 4-10, 14-19 |
| Y | CN 110264017 A (HEFEI SUNGROW NEW ENERGY TECHNOLOGY CO., LTD.) 20 September 2019 (2019-09-20) <br> description, paragraphs 111-276, and figures 1-22 | 4-10, 14-19 |
| A | US 2016372618 A1 (COLE Eric Douglas) 22 December 2016 (2016-12-22) <br> entire document | 1-19 |

Form PCT/ISA/210 (second sheet) (January 2015)

**INTERNATIONAL SEARCH REPORT**
Information on patent family members

International application No.

**PCT/CN2020/102817**

| Patent document cited in search report | | | Publication date (day/month/year) | Patent family member(s) | Publication date (day/month/year) |
|---|---|---|---|---|---|
| CN | 110085517 | A | 02 August 2019 | None | |
| CN | 103022179 | A | 03 April 2013 | None | |
| CN | 103000711 | A | 27 March 2013 | None | |
| CN | 106784105 | A | 31 May 2017 | None | |
| CN | 209266425 | U | 16 August 2019 | None | |
| CN | 110264017 | A | 20 September 2019 | None | |
| US | 2016372618 | A1 | 22 December 2016 | None | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010426784X